Europäisches Patentamt

European Patent Office

Office européen des brevets

(11) Veröffentlichungsnummer : **0 056 845**
**B1**

# EUROPÄISCHE PATENTSCHRIFT

(45) Veröffentlichungstag der Patentschrift :
30.01.85

(51) Int. Cl.⁴ : **H 01 L 21/00**

(21) Anmeldenummer : **81108438.3**

(22) Anmeldetag : **16.10.81**

(54) **Strukturierung von Metalloxidmasken, insbesondere durch reaktives Ionenstrahlätzen.**

(30) Priorität : **27.01.81 DE 3102647**

(43) Veröffentlichungstag der Anmeldung :
**04.08.82 Patentblatt 82/31**

(45) Bekanntmachung des Hinweises auf die Patenterteilung : **30.01.85 Patentblatt 85/05**

(84) Benannte Vertragsstaaten :
**FR GB IT NL**

(56) Entgegenhaltungen :
**EP-A- 0 021 147**
**FR-A- 2 399 486**
**FUJITSU, Band 15, Nr. 4, Dezember 1979, Seiten 111-
120, Tokyo, JP. S. FURUYA: "Fine pattern fabrication
using ion beam etching"**
**IEEE Transactions on Electron Devices, Vol. ED-22,
No. 7, Juli 1975, p. 483-486**

(73) Patentinhaber : **Siemens Aktiengesellschaft
Berlin und München Wittelsbacherplatz 2
D-8000 München 2 (DE)**

(72) Erfinder : **Mathuni, Josef, Dr. Dipl.-Phys.
Englschalkinger Strasse 228
D-8000 München 81 (DE)**
Erfinder : **Unger geb. Lee, Karin
Amalienstrasse 9
D-8000 München 2 (DE)**

## Beschreibung

Die Erfindung betrifft ein Verfahren zur Herstellung feinster Strukturen in der Mikroelektronik mit sehr dünnen Fotolackschichten, die licht-, elektronen- oder röntgenstrahlempfindlich sind, als Maskierung.

Zur Herstellung kleiner und kleinster Strukturen in der Mikroelektronik werden in der Regel Fotolackschichten, die licht, elektronen- oder röntgenstrahlempfindlich sind (z. B. PMMA), als Maskierung verwendet. Mit zunehmender Integration muß auch die Lackdicke verringert werden. Gleichzeitig werden die naßchemischen Ätzverfahren immer mehr durch Trockenätzverfahren wie Plasma-, Sputter- oder Ionenstrahlätzen ersetzt. Die beiden letztgenannten Verfahren arbeiten mit einem gerichteten Ionenstrahl, der je nach Energie und Art der Ionen (Argon, reaktive Gase) einen erheblichen Lackabtrag verursachen kann. Die Abtragsprate des Lackes ist zudem stark abhängig vom Winkel der einfallenden Ionen und hat ihren größten Wert bei etwa 60° Einfallswinkel (Abweichung von der Normalen). Dieser Effekt führt zu schrägen Lackflanken (60°), die sich mit zunehmender Ätzdauer immer weiter zurückziehen. Die Folge davon sind schräge Kanten an der geätzten Schicht und schließlich lateraler Schwund. Dieses Problem tritt vor allem dann auf, wenn das zu ätzende Material keine Selektivität gegenüber dem verwendeten Lack besitzt (vor allem beim Ätzen von Metallen mit Argon) bzw. wenn die zu ätzende Schicht relativ dick ist.

Nach der bisherigen Lösung, wie sie z. B. von M. Cantagrel in IEEE Transactions on Electron Devices, Vol. ED.-22, No. 7, Juli 1975, p. 483-486, beschrieben ist, wird zunächst ein dünner Metallfilm (z. B. Ti, Va, Mn, Al) über der zu ätzenden Schicht aufgebracht und mit Lack strukturiert. Dieser strukturierte Metallfilm dient dann selbst als Maskierung für die darunterliegende Schicht. Dabei wird die Tatsache ausgenutzt, daß bei vielen Metallen die Ätzrate des Oxides mit Ar-Ionen wesentlich geringer ist als die des Metalles selbst. Auf diese Weise kann man zunächst auf naßchemische Weise durch Ionenstrahl- bzw. Sputterätzen mit reinem Argon oder durch Abhebetechnik das entsprechende Metall strukturieren und dann weiter als Maske benutzen, indem man mit einer Mischung aus Ar und etwa 10 % $O_2$ weiterätzt. Das Metalloxid wird dann während des Ätzens an der Oberfläche der Metallmaske gebildet.

Dieses Verfahren hat aber einige Nachteile. So läßt sich die Metallschicht, die als Maske dienen soll, nur sehr schwer strukturieren. Oft findet man eine dünne Oxidschicht vor, die das naßchemische- bzw. Plasmaätzen des Metalls erschwert und wegen des unterschiedlichen Ätzangriffes auch zu undefinierten Unterätzungen führt. Für das Sputter- oder Ionenstrahlätzen der Metallmaske ist andererseits die Selektivität gegenüber den verwendeten Lacken (insbesondere PMMA) meist zu gering, um einen Lackschwund und damit einen lateralen Schwund der Maske zu verhindern. Ein weiterer Nachteil ist, daß bei der anschließenden Ätzung der Schicht mit einem Ar-$O_2$-Gemisch nur solche Materialien abgetragen werden können, die selbst keine gegen Ar-Beschuß resistenten Oxide bilden, z. B. Gold.

Der Erfindung liegt die Aufgabe zugrunde, das eingangs genannte Verfahren zu realisieren. Dies geschieht in der Weise, daß zunächst eine dünne Metalloxidschicht über der zu ätzenden Schicht aufgebracht wird, daraufhin diese Metalloxidschicht mit einer Fotolackschicht abgedeckt, die Fotolackschicht nach einem Muster belichtet und entwickelt wird, anschließend die Metalloxidschicht durch reaktives Sputter- oder Ionenstrahlätzen strukturiert wird und anschließend diese strukturierte Metalloxidschicht als Maskierung der darunterliegenden Schicht für einen Trockenätzvorgang, z. B. Sputter- oder Ionenstrahlätzen, dient. Auf diese Weise wird die Verwendung von Sputter- oder Ionenstrahlätzen auch bei sehr ungünstigen Lackhöhen zu Ätztiefenverhältnissen möglich gemacht.

Nach einer Weiterbildung der Erfindung wird ein Fluorkohlenwasserstoff, z. B. Trifluormethan, als Ätzgas zum Ätzen der Metalloxidschicht selektiv gegenüber den Fotolackschichten verwendet. Unter Verwendung von Trifluormethan als Ätzgas lassen sich die verschiedenen Metalloxide (z. B. $TiO$, $Al_2O_3$, $Ta_2O_5$, $MgO$, $MnO$, $VO$) mit vergleichsweise hoher Selektivität (Faktor 3 bis 10) gegen Fotolacke oder Röntgenlacke (z. B. PMMA) ätzen. Auf diese Weise lassen sich auch mit geringer Lackhöhe sehr feine Strukturen ohne lateralen Schwund auf der Metalloxidmaske herstellen. Der verbleibende Lack kann bei der anschließenden eigentlichen Ätzung zumindest am Anfang noch als zusätzlicher Schutz dienen.

Nach einer weiteren Ausgestaltung der Erfindung wird in der selben Anlage wie die Strukturierung der Metalloxidschicht im darauffolgenden Arbeitsschritt die eigentliche Ätzung der zu ätzenden Schicht mit einem geeigneten Gas, z. B. reinem Argon, ausgeführt. Dies setzt voraus, daß die Maske bereits als Oxid vorliegt. Der Vorteil dieser Lösung besteht darin, daß damit die Anlage (Ionisationsfilamente, Gittersysteme) geschont werden und zum anderen damit alle Arten von Materialien geätzt werden können, und zwar auch diejenigen, die gegen Argonbeschuß resistente Oxide bilden. Der Rest der Metalloxidmaske wird am Schluß, wenn notwendig, mit einer geeigneten Ätze entfernt.

Die Erfindung wird anhand der Figuren erläutert.

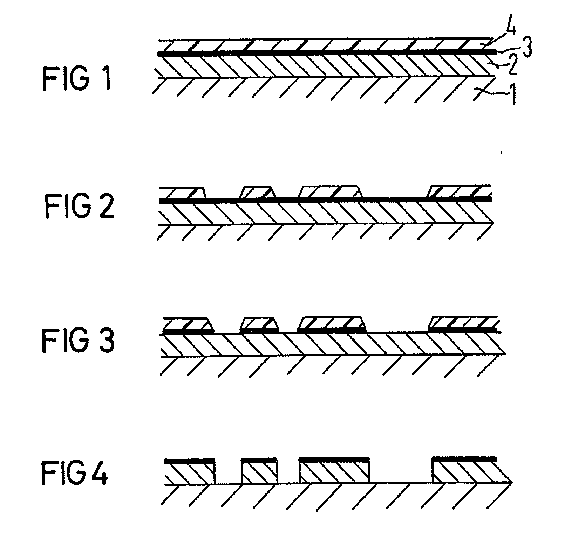

Nach den Figuren wird jeweils ein Substrat 1 verwendet, das aus einer Silizium-Dioxid-Schicht bestehen kann, die auf einem nicht dargestellten Halbleiterplättchen während der Herstellung gebildet wurde. Normalerweise enthält eine solche Halbleiterscheibe mindestens eine in üblicher Weise hergestellte integrierte Schaltung einschließlich ohm'scher Kontakte (die nicht gezeigt sind). Auf diesem Substrat 1 befindet sich eine Schicht 2, die normalerweise durch Trockenätzverfahren strukturiert wird. Darüber wird eine Metalloxidschicht 3 aufgedampft oder aufgestäubt. Als nächstes wird über der Schicht 3 eine Schicht 4 aus einem abziehbaren Maskenmaterial aufgebracht. Dieses Maskenmaterial ist als organisches, polymeres Material gekennzeichnet, das beispielsweise ein Fotolack, ein elektronenstrahl- oder röntgenstrahlempfindlicher Lack sein kann, der in üblicher Weise, beispielsweise durch Schleudern, als Überzug aufgebracht wird (Figur 1).

Beim ersten Arbeitsschritt wird in üblicher Weise der Lack strukturiert (Figur 2). Anschließend wird z. B. durch reaktives Ionenstrahlätzen das Metalloxid 3 an den frei bleibenden Stellen maßgetreu ohne Lackschwund strukturiert (Figur 3). Schließlich wird dann in der selben Anlage im darauffolgenden Arbeitsschritt, z. B. mit Argon, die zu ätzende Schicht geätzt (Figur 4).

**Ansprüche**

1. Verfahren zur Herstellung feinster Strukturen in der Mikroelektronik mit sehr dünnen Fotolackschichten, die licht-, elektronen- oder röntgenstrahlempfindlich sind, als Maskierung, dadurch gekennzeichnet, daß zunächst eine dünne Metalloxidschicht (3) über der zu ätzenden Schicht (2) aufgebracht wird, daraufhin diese Metalloxidschicht mit einer Fotolackschicht (4) abgedeckt, die Fotolackschicht nach einem Muster belichtet und entwickelt wird, anschließend die Metalloxidschicht durch reaktives Sputter- oder Ionenstrahlätzen strukturiert wird und anschließend diese strukturierte Metalloxidschicht als Maskierung der darunterliegenden Schicht für einen Trockenätzvorgang, z. B. Sputter- oder Ionenstrahlätzen, dient.

2. Verfahren nach Anspruch 1, dadurch gekennzeichnet, daß ein Fluorkohlenwasserstoff, z. B. Trifluormethan, als Ätzgas zum Ätzen der Metalloxidschicht (3) selektiv gegenüber der Fotolackschicht (4), Verwendung findet.

3. Verfahren nach den Ansprüchen 1 oder 2, dadurch gekennzeichnet, daß in der selben Anlage wie die Strukturierung der Metalloxidschicht im darauffolgenden Arbeitsschritt die eigentliche Ätzung der zu ätzenden Schicht mit einem geeigneten Gas, z. B. Argon, ausgeführt wird.

**Claims**

1. A method of producing the finest structures in micro-electronics using very thin photo-lacquer layers which are sensitive to light, electrons, or X-rays, as masks, characterised in that a thin metal oxide layer (3) is first applied over the layer (2) to be etched, the metal oxide layer is then covered with a photo-lacquer layer (4), the photo-lacquer layer is exposed according to a design and developed, the metal oxide layer is subsequently structured by reactive sputtering, or ion beam etching, and this structured metal oxide layer then serves for masking the underlying layer in a dry etching process, e. g. sputtering, or ion beam etching.

2. A method as claimed in Claim 1, characterised in that a fluoro-hydrocarbon, e. g. trifluoromethane, is used as etching gas for selectively etching the metal oxide layer (3) in contrast to the photo-lacquer layer (4).

3. A method as claimed in Claim 1 or 2, characterised in that the actual etching of the layer to be etched is carried out with a suitable gas, e. g. argon, in the same apparatus as the structuring of the metal oxide layer in a subsequent operating step.

**Revendications**

1. Procédé de préparation de structures très fines en micro-électronique, avec comme masques des couches très minces de vernis photosensibles qui sont sensibles aux rayons lumineux, aux faisceaux d'électrons ou aux rayons X, caractérisé en ce qu'il consiste à déposer d'abord une mince couche d'oxyde métallique (3) sur la couche (2) à graver, et ensuite à recouvrir cette couche d'oxyde métallique d'une couche de vernis photosensible (4), à exposer la couche de vernis photosensible suivant un modèle et à la développer, à structurer ensuite la couche d'oxyde métallique par une gravure réactive ionique ou par pulvérisation cathodique, et ensuite à se servir de cette couche d'oxyde métallique structurée comme masque de la couche sous-jacente, pour un processus de gravure à sec, par exemple une gravure ionique ou par pulvérisation cathodique.

2. Procédé suivant la revendication 1, caractérisé en ce qu'il consiste à utiliser un hydrocarbure fluoré, par exemple le trifluorométhane, comme gaz de gravure, pour graver la couche d'oxyde métallique (3) sélectivement par rapport à la couche de vernis photosensible (4).

3. Procédé suivant la revendication 1 ou 2, caractérisé en ce qu'il consiste à effectuer la gravure proprement dite de la couche à graver avec un gaz convenable, par exemple avec de l'argon, dans la même installation que celle où s'effectue la structuration de la couche d'oxyde métallique, et dans un stade opératoire venant ensuite.

FIG 1

FIG 2

FIG 3

FIG 4